# EUROPEAN PATENT SPECIFICATION

(11) **EP 1 871 922 B1**
(45) Date of publication and mention of the grant of the patent: **22.07.2009**
(21) Application number: 06716696.7
(22) Date of filing: 24.03.2006
(51) Int. Cl.: C23C 14/08, F01D 5/28

(54) **COATING, SUBSTRATE PROVIDED WITH A COATING AND METHOD FOR THE APPLICATION OF A CORROSION-RESISTANT COATING**
BESCHICHTUNG, MIT EINER BESCHICHTUNG VERSEHENES SUBSTRAT UND VERFAHREN ZUM AUFBRINGEN EINER KORROSIONSBESTÄNDIGEN BESCHICHTUNG
ENROBAGE, SUBSTRAT POURVU D'UN ENROBAGE ET PROCEDE D'APPLICATION D'UN ENROBAGE ANTICORROSION

(30) Priority: 24.03.2005 NL 1028629
(43) Date of publication of application: 02.01.2008
(73) Proprietor: Stichting Materials Innovation Institute (M2I), 2628 CD Delft (NL); Sloof, Willem Gerrit, 2622 DJ Delft (NL)
(72) Inventor: BENNET, Ian, John, NL-2283 GL Rijswijk (NL)
(74) Representative: van Westenbrugge, Andries
(86) International application number: PCT/NL2006/050063
(87) International publication number: WO 2006/118455

(56) References cited:
- US-A- 3 918 139
- US-A- 4 123 594
- US-A- 4 346 137
- US-A1- 2003 041 928
- US-B1- 6 183 888
- US-B1- 6 458 473

## Description

The present invention relates to a coating comprising a ferrous metal aluminium or ferrous metal chromium alloy, said alloy forming an aluminium oxide or chromium oxide skin, respectively, on contact with oxygen, said skin being impermeable to oxygen.

A coating of this type is used notably with materials that are exposed to high temperatures. Examples of this are turbine blades in combustion engines, applications in electronics such as photovoltaic devices, sensors and the like.

If, for example, a nickel aluminium alloy is used, aluminium oxide will be formed on the surface at relatively high temperature that in principle forms a skin impermeable to oxygen, as a result of which protection for the underlying metal is obtained. It is important, however, that such an oxide skin formed at elevated temperatures has sufficient adhesion to the underlying metal.

In the prior art, a further protective layer is applied to the coating. In US 4,123,592, for example, a thin platinum layer is applied by sputtering after the application of the coating. As a result of the application of platinum to the surface the diffusion rate of aluminium us increased, as a result of which rapid closure of the surface takes place in the event of damage to the surface.

A coating is also disclosed in US 6,183,888 to which a further protective layer containing platinum is applied.

US 6,458,473 B1 describes a coating built up of several layers.

US 2003/0041928 Al describes the application of a coating and the subsequent polishing of the surface before the application of the protective oxide. Platinum is applied in a separate step.

US 4,123,594 describes a coating consisting of different layers and in which 1 - 30 % (m/m) platinum or palladium is incorporated.

US 4,346,137 describes a coating built up of different layers each with a different coefficient of expansion.

A process is disclosed in US 3,918,139 A in which 5 - 10 % (m/m) platinum is deposited in a coating in a separate step. Adhesion between the protective oxide layer and the bond coating is achieved with rare earths.

The aim of the present invention is to provide a coating, which can be used at high temperatures, can be applied simply and inexpensively and where it is not necessary to apply a further protective layer thereon. That is to say the objective is to provide a coating, where on heating a sealing oxide layer is formed that has good adhesion to the original coating.

This aim is realised with the coating described above with the characteristic features of Claim 1. The metal from the platinum group, such as platinum, palladium or rhodium is at least near the free interface of the coating, i.e. the part of the coating facing away from the underlying substrate integrated into the alloy, i.e. forms part of the alloy. In contrast to the prior art, a further layer applied thereon is not provided. The alloy as applied has in principle a constant composition during application, i.e. the same percentage of a metal from the platinum group is always applied. In a manner known per se, a chromium and/or aluminium oxide layer will subsequently be formed. Only a relatively small percentage of the metal from the platinum group is necessary. A value of 0.1 % (m/m) is mentioned as a lower limit. A value of about 0.5 % (m/m) is mentioned as maximum.

Surprisingly it has been found that when using such an alloy significantly improved adhesion occurs between the oxide formed and the original coating.

Although not essential for the invention it is assumed that reduced adhesion of the oxide layer to the coating, as has been observed, is caused not only by the presence of sulphur and carbon but also by the presence of sodium, potassium or calcium. These materials can be present as impurities during formation of the alloys in amounts of 1 ppm - 0.1 % (m/m). As an example, the lining material of furnaces in which the ferrous metal chromium alloy or ferrous metal aluminium alloy is melted may be mentioned. It is assumed that by the addition of platinum or palladium, sodium, potassium or calcium is immobilized in the alloy. As a result, sodium, potassium or calcium cannot diffuse to the interface, where they have an adverse effect on the adhesion between the oxide skin formed/to be formed and the alloy. It has been observed that the adhesion between the alloy and the oxide layer can be decreased by a factor of more than 2 because of the presence of sodium, potassium or calcium.

"Ferrous metal" is understood to relate here in particular to iron alloys, nickel alloys and cobalt alloys. More particularly, at high temperatures, nickel alloys such as nickel aluminium alloys and more particularly β-nickel aluminium alloys are used. In turbine motors, where the temperature can reach more than 1600 °C and the surface temperature of the blades is about 1200 °C, the β-NiAl alloys described above are employed. At such high temperatures, α-Al₂O₃ is formed as a sealing oxide layer. In the prior art, delamination of such an oxide layer has been observed.

According to the present invention, by adding the alloy from the platinum group described above, at least near the interface between the alloy and the oxide skin it has been found that the adhesion of such an oxide skin is significantly improved, while it is still guaranteed that such an oxide skin is impermeable.

It will be understood that the same mechanism is also observed in other applications. At somewhat lower temperatures, i.e. up to 900 °C, preference is given to the combination of nickel or iron with chromium, Cr₂O₃ being formed on heating. At higher temperatures, i.e. above 900 °C, preference is given to aluminium as an addition to iron, nickel or cobalt.

The invention also relates to a substrate comprising a backing material such as a turbine blade and the coating described above applied thereon. Any other backing material can be used instead of a turbine blade.

The invention also relates to a method for the application of a corrosion-resistant protective layer to a substrate, comprising deposition of a coating on said substrate, which coating comprises a ferrous metal aluminium alloy, a ferrous metal chromium alloy, which alloy forms an aluminium oxide or chromium oxide skin, respectively, on contact with oxygen, which skin is impermeable to oxygen, characterised in that only a single coating is deposited on said substrate, wherein the alloy of said coating contains 0.1 - 0.5 % (m/m) of a metal from the platinum group and sodium, potassium or calcium. That is to say the addition of a metal from the platinum group described above takes place during the application of the coating. However, this addition is incorporated in the coating and is not applied thereon. Only a single coating, which provides the protective oxide skin, is applied to the substrate. A significant reduction in costs can be obtained by the application in one step in contrast to the state of the art.

The application of such a coating can be achieved with any method known in the state of the art. According to an advantageous embodiment, PVD or plasma spraying is employed.

With the techniques mentioned here, wherein the protective coating is grown on, it is possible, if the metal from the platinum alloy is added at that moment, to vary the concentration of the metal from the platinum group during the growth, i.e. in particular to add the desired quantity of platinum or palladium when the boundary front of the layer is being grown. After all, this part will be converted first to aluminium or chromium oxide. However, in view of the small amount of material from the platinum group, it is not important for cost reasons to add the metal from the platinum group already during the first deposit of the layer.

The layer thickness of such a coating is preferably between 50 and 200 µm.

It is of course possible to add materials known in the state of the art to the coating or to apply further layers thereon.

After reading the above, variants will be immediately apparent to those skilled in the art that are obvious and fall within the scope of the appended claims.

## Claims

1. Coating with good adhesion in the presence of sodium, potassium and calcium impurities, comprising a ferrous alloy, nickel alloy or cobalt alloy containing aluminium or chromium, said alloy forming an aluminium or chromium oxide skin on contact with oxygen and which is impermeable to oxygen, **characterised in that** the coating comprises 0.1-0.5 (m/m) of a metal from the platinum group adjacent the oxide layer.

2. Coating according to Claim 1, wherein said alloy contains 1 ppm - 0.1% (m/m) sodium, potassium or calcium.

3. Coating according to one of the preceding claims, wherein said alloy comprises a NiAl alloy.

4. Substrate comprising a support and a protective layer applied thereon, wherein said protective layer comprises solely a coating according to one of the preceding claims.

5. Substrate according to Claim 4, comprising a turbine blade.

6. Method for applying an corrosion resistant coating to a substrate having good adhesion properties in the presence of sodium, potassium and calcium impurities, the method comprising depositing a single coating consisting of a ferrous alloy, nickel alloy or cobalt alloy containing aluminium or chromium, which alloy forms an aluminium oxide or chromium oxide skin, respectively, on contact with oxygen, and 0,1-0.5 (m/m) of a platinum group metal on the substrate such that the aluminium oxide or chromium oxide coating is impermeable to oxygen.

7. Method according to Claim 6 comprising the addition of the metal from the platinum group during the deposition process.

8. Method according to Claim 6 or 7 comprising PVD.

9. Method according to one of Claims 7 or 8 comprising plasma spraying.

## Patentansprüche

1. Beschichtung mit guter Adhäsion in Gegenwart von Natrium-, Kalium- und Calciumverunreinigungen, umfassend eine Eisenlegierung, Nickellegierung oder Kobaltlegierung, die Aluminium oder Chrom enthält, wobei die Legierung bei Kontakt mit Sauerstoff eine Aluminium- oder Chromoxidhaut bildet, welche für Sauerstoff undurchlässig ist, **dadurch gekennzeichnet, dass** die Beschichtung 0,1-0,5 (m/m) eines Metalls aus der Platingruppe an die Oxidschicht angrenzend umfasst.

2. Beschichtung nach Anspruch 1, wobei die Legierung 1 ppm - 0,1 % (m/m) Natrium, Kalium oder Calcium enthält.

3. Beschichtung nach einem der vorangehenden Ansprüche, wobei die Legierung eine NiAl-Legierung umfasst.

4. Substrat umfassend einen Träger und eine darauf aufgebrachte Schutzschicht, wobei die Schutzschicht ausschließlich eine Beschichtung nach einem der vorangehenden Ansprüche umfasst.

5. Substrat nach Anspruch 4, umfassend eine Turbinenschaufel.

6. Verfahren zum Aufbringen einer korrosionsbeständigen Beschichtung auf ein Substrat mit guten Adhäsionseigenschaften in Gegenwart von Natrium-, Kalium- und Calciumverunreinigungen, wobei das Verfahren das Abscheiden einer einzelnen Beschichtung bestehend aus einer Eisenlegierung, Nickellegierung oder Kobaltlegierung, die Aluminium oder Chrom enthält, wobei diese Legierung bei Kontakt mit Sauerstoff eine Aluminiumoxid- bzw. Chromoxidhaut bildet, und 0,1-0,5 (m/m) eines Platingruppenmetalls auf das Substrat umfasst, so dass die Aluminiumoxid- oder Chromoxidbeschichtung für Sauerstoff undurchlässig ist.

7. Verfahren nach Anspruch 6, umfassend die Zugabe des Metalls aus der Platingruppe während des Abscheidungsprozesses.

8. Verfahren nach Anspruch 6 oder 7, umfassend PVD.

9. Verfahren nach einem der Ansprüche 7 oder 8, umfassend Plasmaspritzen.

## Revendications

1. Revêtement présentant une bonne adhérence en présence d'impuretés de sodium, de potassium et de calcium, comprenant un alliage ferreux, un alliage de nickel ou un alliage de cobalt contenant de l'aluminium ou du chrome, ledit alliage formant une pellicule d'oxyde d'aluminium ou de chrome lors du contact avec l'oxygène et qui est imperméable à l'oxygène, **caractérisé en ce que** le revêtement comprend 0,1-0,5 (m/m) d'un métal provenant du groupe du platine adjacent à la couche d'oxyde.

2. Revêtement selon la revendication 1, dans lequel ledit alliage contient 1 ppm - 0,1 % (m/m) de sodium, de potassium ou de calcium.

3. Revêtement selon l'une des revendications précédentes, dans lequel ledit alliage comprend un alliage de NiAl.

4. Substrat comprenant un support et une couche de protection appliquée dessus, dans lequel ladite couche de protection comprend uniquement un revêtement selon l'une des revendications précédentes.

5. Substrat selon la revendication 4, comprenant une lame de turbine.

6. Procédé d'application d'un revêtement résistant à la corrosion à un substrat ayant de bonnes propriétés d'adhérence en présence d'impuretés de sodium, de potassium et de calcium, ledit procédé comprenant le dépôt d'un revêtement unique constitué d'un alliage ferreux, d'un alliage de nickel ou d'un alliage de cobalt contenant de l'aluminium ou du chrome, ledit alliage formant une pellicule d'oxyde d'aluminium ou d'oxyde de chrome, respectivement, lors du contact avec l'oxygène, et 0,1-0,5 (m/m) d'un métal du groupe du platine sur le substrat, de sorte que le revêtement d'oxyde d'aluminium ou d'oxyde de chrome soit imperméable à l'oxygène.

7. Procédé selon la revendication 6, comprenant l'addition du métal du groupe platine pendant le procédé de dépôt.

8. Procédé selon la revendication 6 ou 7, comprenant un dépôt physique en phase vapeur.

9. Procédé selon l'une des revendications 7 ou 8, comprenant une pulvérisation par plasma.
